Europäisches Patentamt

European Patent Office

Office européen des brevets

(19)

(11) Numéro de publication : **0 071 505 B1**

# FASCICULE DE BREVET EUROPÉEN

(12)

(45) Date de publication du fascicule du brevet :
09.10.85

(51) Int. Cl.⁴ : **H 03 L  7/00, H 04 N  5/95**

(21) Numéro de dépôt : **82401304.9**

(22) Date de dépôt : **09.07.82**

(54) **Procédé et dispositif pour l'échantillonnage d'un signal sinusoidal par un signal de fréquence multiple.**

(30) Priorité : **24.07.81 FR 8114421**

(43) Date de publication de la demande :
**09.02.83 Bulletin 83/06**

(45) Mention de la délivrance du brevet :
**09.10.85 Bulletin 85/41**

(84) Etats contractants désignés :
**BE DE GB**

(56) Documents cités :
**FR-A- 2 367 398
US-A- 3 789 308
ELECTRONIC ENGINEERING, vol. 49, no. 595, août 1977, pages 26-27, Londres (GB); M.N.Y. SHUM: "Adaptive bandwidth binary digital phase locked loop"**

(73) Titulaire : **THOMSON-CSF
173, Boulevard Haussmann
F-75379 Paris Cedex 08 (FR)**

(72) Inventeur : **Rougeolle, Daniel
THOMSON-CSF SCPI 173, bld Haussmann
F-75379 Paris Cedex 08 (FR)**
Inventeur : **Porrot, Pascal
THOMSON-CSF SCPI 173, bld Haussmann
F-75379 Paris Cedex 08 (FR)**

(74) Mandataire : **Turlèque, Clotilde et al
THOMSON-CSF SCPI 173, Bld Haussmann
F-75379 Paris Cedex 08 (FR)**

Jouve, 18, rue St-Denis, 75001 Paris, France

## Description

La présente invention se rapporte à un procédé permettant d'échantillonner un signal sinusoïdal de fréquence déterminée par un signal de fréquence multiple de cette fréquence déterminée et à un dispositif mettant en œuvre ce procédé.

Il est connu d'effectuer un tel échantillonnage d'un signal d'entrée, mais les dispositifs de l'art connu présentent une certaine inertie en ce qui concerne le réglage de la phase relative entre le signal d'échantillonnage et le signal d'entrée.

Pour pallier cet inconvénient, le procédé de l'invention réalise un rattrapage par saut instantané qui permet d'obtenir le déphasage relatif voulu entre le signal d'échantillonnage et le signal d'entrée ; c'est-à-dire que l'on cale le signal d'échantillonnage sur une certaine valeur référence de la phase du signal d'entrée, cette valeur référence pouvant d'ailleurs être nulle.

Il est connu dans un article intitulé « Adaptive bandwidth binary digital phase locked loop », publié dans Electronic Engineering, août 1977, de mesurer une erreur de phase entre deux signaux dans le but d'agir sur un signal d'horloge.

Le procédé selon l'invention réalise également une mesure de phase qui commande une action sur un signal d'horloge, cette action étant dans le procédé selon l'invention un rattrapage de phase par saut instantané fonction de la mesure de phase.

L'invention a pour objet un procédé d'échantillonnage d'un signal sinusoïdal de fréquence F par un signal d'échantillonnage de fréquence multiple de cette fréquence permettant d'obtenir un déphasage relatif minimum entre le signal d'échantillonnage A(t) et une valeur de phase référence du signal d'entrée E(t), caractérisé en ce qu'il comporte les étapes suivantes :

— génération d'un signal d'échantillonnage A(t) de fréquence kF, à phase variable par rapport au signal d'entrée E(t) de fréquence égale à ladite fréquence déterminée, k étant un nombre entier positif ; cette phase étant réglable par incréments de T/kp, T étant la période du signal d'entrée et p un nombre entier positif ; le signal d'échantillonnage A(t) étant asservi par rapport à ce signal d'entrée E(t) ;

— génération d'un signal référence de phase obtenu à partir du signal d'échantillonnage A(t), et mesure de l'écart de phase relative du signal d'échantillonnage A(t) par rapport au signal d'entrée E(t) ;

— choix parmi les réglages de phase possibles du signal d'échantillonnage A(t) pour minimiser l'écart de phase relative de ce signal par rapport à la valeur de phase référence du signal d'entrée E(t).

L'invention a également pour objet un dispositif mettant en œuvre un tel procédé.

L'invention sera mieux comprise au moyen de la description ci-après et des figures annexées parmi lesquelles :

la figure 1 est un schéma représentatif du dispositif de l'invention.

la figure 2 est un schéma représentatif d'une variante du dispositif de l'invention.

les figures 3 et 4 représentent des diagrammes explicatifs du dispositif de l'invention.

la figure 5 représente des diagrammes explicatifs d'une variante du dispositif de l'invention.

Avec un signal sinusoïdal E(t) de fréquence déterminée F à convertir en numérique avec un signal d'échantillonnage de fréquence kF asservi sur ce signal sinusoïdal E(t) entrant, quelles que soient les variations de phase entre le signal asservi de fréquence kF et l'entrée de fréquence F, on désire obtenir à tout instant une erreur de phase minimale entre le signal d'échantillonnage A(t) et une valeur de phase référence du signal d'entrée E(t), k étant un nombre entier positif. Cette valeur de phase référence du signal d'entrée E(t) peut, d'ailleurs, être nulle.

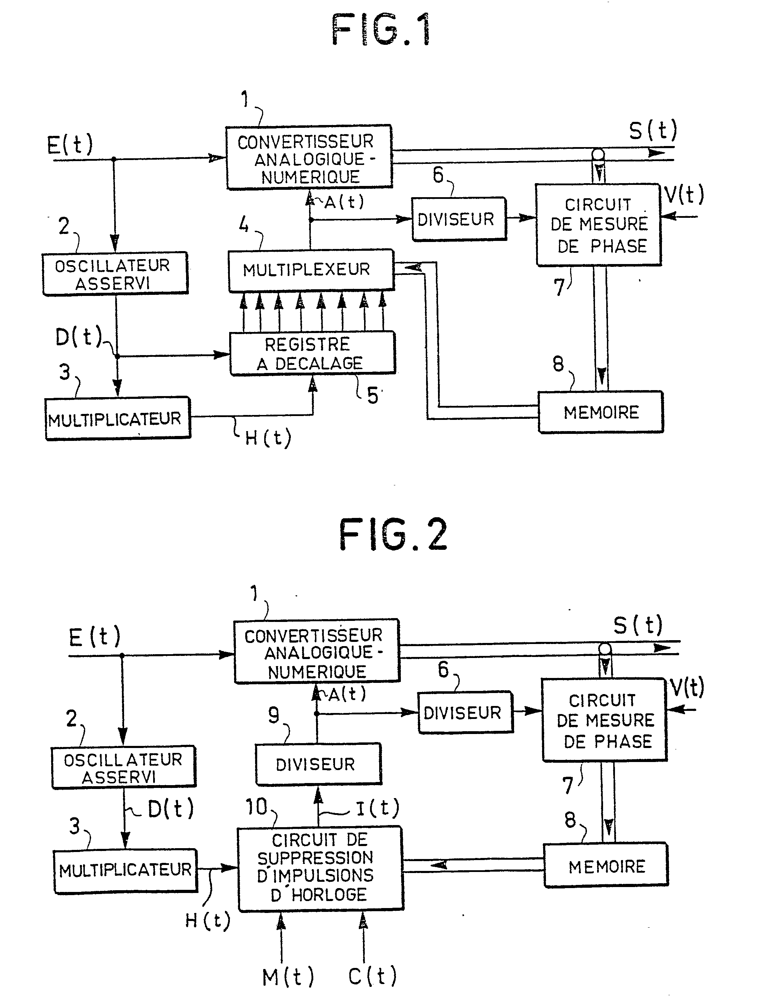

La figure 1 représente un dispositif d'échantillonnage uivant l'invention. Le signal d'entrée E(t) est par exemple, de la forme $A \sin (2 \pi Ft)$. Un oscillateur asservi 2, de type VCO, tiré de l'anglais « Voltage Control oscillator », permet d'obtenir un signal D(t) de fréquence kF asservi sur ce signal E(t) de fréquence F.

Le signal d'échantillonnage A(t) obtenu à partir de ce signal D(t) de fréquence kF a sa phase réglable par rapport au signal d'entrée E(t) en p positions possibles ; p étant un nombre entier positif, c'est-à-dire que la mise en phase entre le signal d'échantillonnage A(t) et la phase référence du signal d'entrée E(t) peut être effectuée avec une erreur inférieure à T/kp, T étant la période du signal d'entrée. L'échantillonnage est réalisé par exemple sur les fronts montants du signal A(t).

Ainsi le signal E(t) est échantillonné par le signal A(t) en utilisant un convertisseur analogique-numérique 1, dans lequel ces deux signaux E(t) et A(t) sont entrés, on obtient en sortie le signal numérique échantillonné S(t) ; S(t) peut être par exemple un signal à mots binaires multibits.

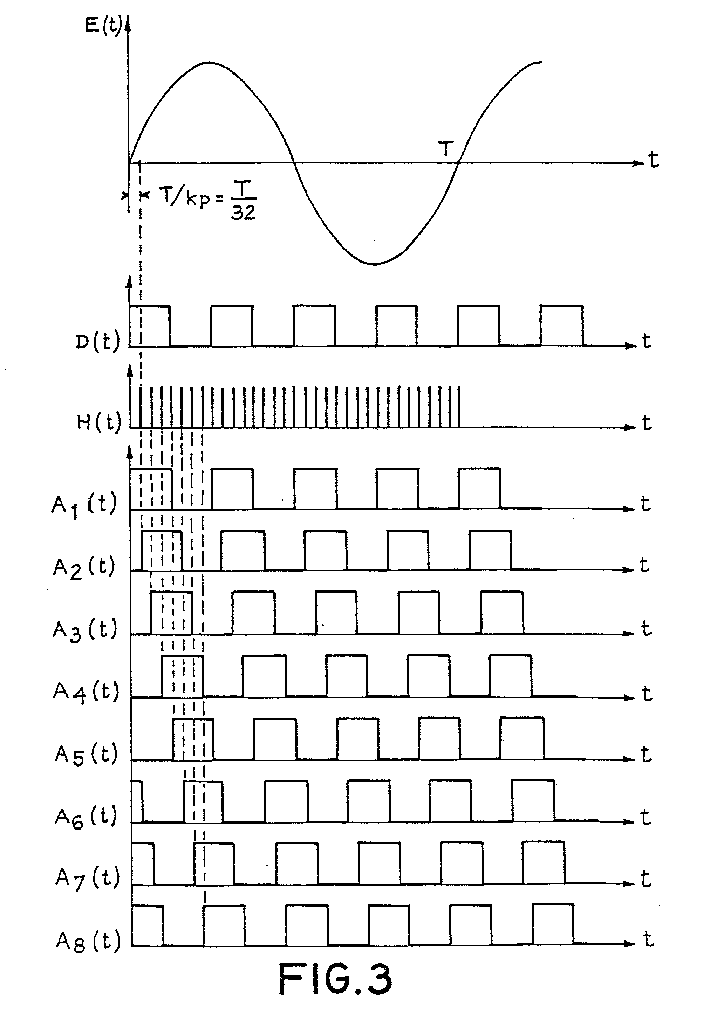

La figure 3 illustre le signal d'entrée E(t) de fréquence F et les p positions Ai(t) que peut prendre le signal d'échantillonnage A(t) à la sortie du circuit de décalage, parmi lesquelles l'une va être choisie. Dans le cas considéré à la figure on a k = 4 et p = 8 et donc 8 décalages possibles du signal d'échantillonnage A(t).

Ainsi lorsque la valeur de p augmente, la précision du réglage de la phase relative du signal d'échantillonnage A(t) par rapport au signal d'entrée E(t) augmente.

La mesure de phase relative entre le signal d'échantillonnage A(t) et le signal d'entrée E(t) est effectuée dans un circuit de mesure de phase 7. Ce circuit 7 effectue la mesure de l'écart de phase entre le signal S(t) et un signal de fréquence F obtenu à partir du signal d'échantillonnage A(t) après division par k en fréquence dans un diviseur de fréquence 6. Ce signal de fréquence F sert donc de référence en phase par rapport au signal d'entrée E(t).

Le résultat de la mesure de l'écart de phase permet la sélection d'une des phases du signal d'échantillonnage A(t) pour minimiser ainsi la phase relative entre ce signal A(t) et la valeur référence de phase du signal d'entrée E(t).

Pour effectuer cette sélection on peut utiliser une mémoire 8 par exemple de type « non volatile programmable à lecture seule » ou « PROM » (de l'anglais Programmable Read Only Memory) dans laquelle a été mémorisé un tableau permettant de faire correspondre à l'écart de phase mesuré l'un des mots de commande.

Pour obtenir un signal d'échantillonnage A(t) de phase réglable en p positions par rapport au signal d'entrée, le signal sortant de l'oscillateur asservi, 2, de fréquence kF est entré dans un registre à décalage 5 commandé par une horloge H(t) de fréquence pkF obtenue par multiplication par p dans un multiplicateur 3 de la fréquence kF du signal sortant de l'oscillateur asservi. On peut réaliser cette multiplication de fréquence kF par p, par exemple en utilisant un filtre accordé sur la fréquence pkF que l'on désire obtenir. Les sorties de ce registre à décalage 5 sont reliées aux entrées d'un multiplexeur 4 qui sélectionne l'une des p sorties de ce registre à décalage 5, et ainsi on sélectionne l'une des p phases possibles du signal d'échantillonnage A(t). Ce multiplexeur est commandé par un mot de commande sortant de la mémoire 8 fonction de l'écart de phase relative entre le signal d'échantillonnage A(t) et le signal d'entrée E(t).

Le signal sortant du circuit de mesure de phase 7 sert par exemple d'adresse à la mémoire 8 de type « PROM ». Compte tenu de l'erreur de phase et du rattrapage par pas de T/kp, une entrée du multiplexeur est sélectionnée. Cela conduit à une erreur de phase $\gamma$ résiduelle telle que $0 \leqslant \gamma \leqslant T/kp$. Le convertisseur analogique numérique est du type comprenant une sortie en parallèle, dans une autre variante non représentée il est tout aussi possible de considérer un convertisseur analogique-numérique avec une sortie série. Ceci explique l'existence des bus représentés en double-ligne sur la figure 1 et aussi sur la figure 2.

Le signal V(t) est un signal de validation de la mesure de phase. C'est par exemple un signal logique qui lorsqu'il est à l'état « 1 » constitue une fenêtre dans laquelle la mesure de phase peut avoir lieu ; en dehors de cette fenêtre le calcul de mesure de phase est invalidé.

La figure 2 illustre une autre façon d'obtenir un signal d'échantillonnage A(t) réglable en phase par rapport au signal d'entrée E(t) ; le procédé d'échantillonnage reste le même que celui exposé précédemment, seuls les circuits 4 et 5 de la figure 1 sont remplacés par les circuits 9 et 10 de la figure 2.

Au lieu de sélectionner l'une des p sorties d'un registre à décalage 5 par l'intermédiaire d'un multiplexeur 4, on supprime un certain nombre d'impulsions du signal d'horloge de fréquence pkF obtenu à la sortie du multiplicateur 3. En supprimant ces impulsions on obtient un signal I(t) et en divisant ensuite la fréquence de ce signal par p, on obtient un signal d'échantillonnage A(t) de phase réglable en p positions par rapport au signal d'entrée E(t).

Pour cela un circuit de suppression d'impulsions 10 relié à la sortie du multiplicateur 3 est commandé par un signal provenant de la mémoire 8 dans lequel a été mémorisé un tableau de correspondance. Le type de commande de la mémoire 8 est le même que celui décrit pour la figure 1 : c'est-à-dire que cette mémoire est par exemple du type « PROM ». Elle contient un tableau de correspondance qui permet de sortir un mot de commande fonction de l'écart de phase mesuré. Ce circuit de suppression comporte en outre deux entrées de commande recevant les signaux M(t) et C(t).

Le signal M(t) est un signal d'autorisation de modification de la phase du signal d'échantillonnage A(t). Le signal C(t) est un signal permettant le chargement de compteurs à une valeur égale au nombre d'impulsions du signal de fréquence pkF à supprimer, ce qui permettra ensuite de décompter ce nombre d'impulsions à supprimer. La sortie du circuit de suppression est reliée à l'entrée d'un diviseur par p, 9.

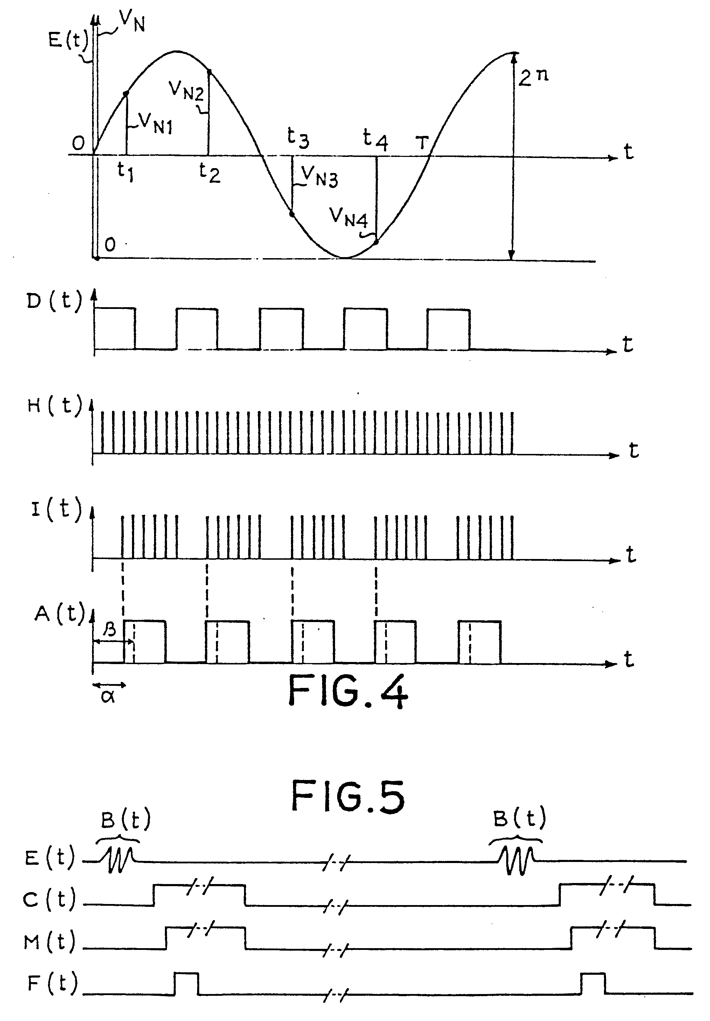

Le diagramme de la figure 4 illustre le processus de conversion.

Dans un exemple de réalisation concrète, le convertisseur analogique-numérique 1 est un convertisseur à sorties parallèles, par exemple fournissant un mot codé binaire de 9 bits, le bit de plus fort poids représentant le signe. L'amplitude crête à crête du signal sinusoïdal peut être décomposée en $2^n$ incréments, soit 512 dans le cadre de l'exemple choisi.

De façon usuelle, le signal d'échantillonnage A(t) est dérivé d'un signal D(t) de fréquence kF, ce signal étant asservi en phase sur le signal d'entrée E(t). Pour ce faire, on utilise un multiplicateur de fréquence 3 de type connu. k a été choisi égal à 4. Les impulsions constituant les signaux respectifs D(t), H(t), I(t) et A(t) ont été représentés sur cette figure.

Le déphasage du signal A(t) par rapport au signal E(t) est égal à $\alpha$, représenté sur l'axe des temps :

L'échantillonnage a lieu aux instants $t_1$, $t_2$, $t_3$ et $t_4$, (à l'intérieur d'une période T du signal et des mots successifs de 9 bits représentant l'amplitude de ces échantillons $V_{N1}$ à $V_{N4}$ sont disponibles sur les sorties parallèles du convertisseur analogique-numérique 1 après les instants d'échantillonnage.

Dans de nombreuses applications le déphasage entre le signal à convertir E(t) et le signal d'échantillonnage A(t) doit être constant et égal à une valeur préétablie définie en amplitude et en signe. Dans ce qui suit cette valeur référence est appelée $\beta$ ou valeur de consigne.

Dans la réalité, comme représenté sur le diagramme de la figure 4, le déphasage réel $\alpha$ diffère

de la valeur de consigne β, qui serait obtenu par les signaux d'échantillonnage, représentée en traits interrompus (seuls les fronts montants caractérisant les instants d'échantillonnage ont été représentés).

Il existe de nombreuses méthodes pour minimiser l'écart entre α et β que l'on appellera dans ce qui suit erreur de phase résiduelle φ, φ étant donné par la relation : φ = β − α.

Le procédé de mesure de l'erreur de phase résiduelle φ sort du cadre de la présente invention. Cependant il peut être utile de décrire brièvement un procédé permettant cette mesure avec rapidité et précision particulièrement adapté à la présente invention.

Selon ce procédé, on échantillonne le signal d'entrée E(t) à convertir, de manière analogue à ce qui a été décrit en relation avec le diagramme de la figure 4, à l'aide d'un signal A(t) de fréquence quadruple de la fréquence du signe E(t). Dans le cadre de l'exemple choisi, le convertisseur analogique-numérique fournit un mot binaire de 9 bits, le bit de plus fort poids représentant le signe de l'échantillon. Il y a donc 512 niveaux numériques possibles.

Avec un signal d'entrée sinusoïdal de la forme E(t) = A sin (2 π Ft), on obtient à l'intérieur d'une période, l'échantillon référencé $V_{N1}$, qui représente sin α et l'échantillon $V_{N2}$ qui représente cos α. Lorsque la valeur numérique de l'échantillon est supérieure à 256 (arche positive de la sinusoïde) on utilise directement cette valeur numérique pour le calcul des deux fonctions. Dans le cas contraire c'est-à-dire entre 0 et 256 (arche négative), on complémente à deux la valeur numérique fournie par le convertisseur. La discrimination s'effectue par l'examen du bit $2^8$ représentant le signe. En réalité les valeurs échantillonnées représentent respectivement A sin φ et A cos φ, A étant l'amplitude maximale du signal analogique.

Pour s'affranchir du coefficient A, on calcule ensuite tgφ ou cotgφ, selon que A|sinφ < A|cos φ ou que A|sin φ < A|cos φ. Pour ce faire on effectue la comparaison entre ces deux dernières valeurs.

Selon ce procédé, on calcule les valeurs absolues de tgφ et cotg φ, ce de la manière suivante :

$$|tg\phi = A|sin \phi \times 1/A|cos \phi$$

$$et \ |cotg \ \phi = A|cos \phi \times 1/A|sin \phi$$

L'inversion des fonctions A|cos φ et A|sin φ peut être réalisée à l'aide de mémoires de type « PROM », analogues à celles mises en œuvre dans le dispositif décrit en relation avec la figure 1, et adressées par les mots binaires représentant A|cos φ et A|sin φ.

Comme il vient d'être rappelé selon le résultat de la comparaison entre les valeurs A|sin φ et A|cos φ, dans une dernière étape du procédé, l'angle φ est calculé respectivement à partir de tg φ ou cotg φ. On peut également, pour effectuer ce calcul, utiliser une mémoire de type « PROM »

adressée par le mot binaire représentant tg φ ou cotg φ et fournissant un mot binaire sur sa sortie représentant l'erreur de phase résiduelle recherchée.

Par ce procédé, la mesure de φ est indépendante de l'amplitude du signal sinusoïdal et la précision obtenue dépend uniquement du nombre de bits fournis par le convertisseur analogique-numérique. Dans le cadre de l'exemple choisi, la précision avec 9 bits est supérieure à 1°.

Cette dernière méthode permet donc de s'affranchir de l'amplitude du signal d'entrée E(t), ce qui est très important lorsque cette amplitude varie par exemple dans le cas d'un signal « Burst » en vidéo. On obtient de plus un maximum de précision avec une grande vitesse de calcul.

Cette méthode de mesure de phase φ ainsi que le dispositif illustré à la figure 2, peuvent être considérés par exemple avec un signal d'entrée E(t) constitué par un signal télévision PAL ou NTSC, avec p = 8. Le signal composite PAL ou NTSC comporte au début de chaque ligne une salve ou « Burst » B(t) constituée d'une fraction de la sous-porteuse couleur. Ce signal sinusoïdal permet de faire une mesure de la phase d'échantillonnage du signal A(t) et de la corriger à chaque ligne pour que ce signal d'échantillonnage soit en phase avec la sous-porteuse.

Pour ce faire on supprime à chaque ligne, après la mesure de phase grâce au circuit 10, un certain nombre d'impulsions du signal de fréquence pkF (avec p = 8, k = 4) pour obtenir l'écart de phase minimum du signal d'échantillonnage A(t) par rapport au signal de sous-porteuse. Le signal V(t) ne valide la mesure de phase que pendant la durée du signal B(t).

Sur la figure 5, le signal E(t) est un signal de télévision composite du type mis en œuvre dans un système simultané de télévision en couleur ; ce signal étant divisé en intervalles de temps représentant des lignes de balayage d'un organe de visualisation et comportant au début de ces intervalles une salve ou « Burst » de signaux sinusoïdaux haute fréquence dits de sous-porteuse B(t). Le signal C(t) représente le signal de chargement des compteurs qui sont chargés au nombre d'impulsions du signal de fréquence pkF (avec p = 8 et k = 4) à supprimer dans le circuit 10. Le signal M(t) est le signal d'autorisation de modification de la phase φ et F(t) est la fenêtre de durée permettant de supprimer le bon nombre d'impulsions du signal de fréquence pkF, pour régler la phase du signal d'échantillonnage A(t).

Dans le cas où le signal d'entrée E(t) est un signal télévision, le déphasage minimum à obtenir est le déphasage entre le signal d'échantillonnage et la sous-porteuse couleur. Celle-ci a une fréquence F de l'ordre 4 mégahertz. Dans ce cas, le déphasage minimum que l'on puisse obtenir est 1/32 × 360° = 11°.

Le convertisseur analogique numérique est à titre d'exemple un convertisseur analogique-numérique 9 bits à sortie parallèle de type DC 1019 commercialisé par la firme TRW.

Le dispositif de l'invention peut notamment, être appliqué aux magnétoscopes.

**Revendications**

1. Procédé d'échantillonnage d'un signal sinusoïdal E(t) de fréquence F par un signal d'échantillonnage A(t) de fréquence multiple kF, ces deux signaux ayant un déphasage relatif minimum, caractérisé en ce qu'il comporte les étapes suivantes :

génération d'un signal D(t) de fréquence kF multiple de la fréquence d'entrée asservi en phase sur le signal d'entrée E(t),

génération d'un signal d'échantillonnage A(t) de fréquence kF, à partir du signal D(t), à phase réglable par rapport au signal d'entrée E(t) par incréments de T/kp, T étant la période du signal d'entrée et p un nombre entier positif,

génération d'un signal référence de phase obtenu à partir du signal d'échantillonnage A(t) et mesure de l'écart de phase relative du signal d'échantillonnage A(t) par rapport au signal d'entrée E(t),

choix parmi les réglages de phase possibles du signal d'échantillonnage A(t) pour minimiser l'écart de phase relative de ce signal par rapport à la valeur de phase référence du signal d'entrée E(t).

2. Procédé suivant la revendication 1, caractérisé en ce que le signal numérique S(t) sortant du convertisseur analogique-numérique 1 est un signal à mots binaires multibits.

3. Procédé suivant la revendication 1, caractérisé en ce que la valeur de phase référence du signal d'entrée est nulle.

4. Procédé suivant la revendication 2, caractérisé en ce que le signal d'entrée E(t) est le signal de télévision composite d'un système simultané de télévision en couleur, ce signal de télévision étant divisé en intervalles de temps représentant des lignes de balayage d'un organe de visualisation et comportant au début de ces intervalles une salve de signaux sinusoïdaux haute fréquence dits de sous-porteuse, p étant égal à 8 et k égal à 4n avec n entier plus grand ou égal à 1.

5. Procédé suivant la revendication 4, caractérisé en ce que le système simultané de télévision en couleur est le « PAL ».

6. Procédé suivant la revendication 4, caractérisé en ce que le système simultané de télévision en couleur est le « NTSC ».

7. Dispositif d'échantillonnage d'un signal sinusoïdal E(t) de fréquence F par un signal d'échantillonnage A(t) de fréquence multiple, kf, ces deux signaux ayant un déphasage relatif minimum, caractérisé en ce qu'il comporte

un oscillateur asservi (2) qui permet de générer un signal de référence de phase D(t) de fréquence kF asservi en phase sur le signal d'entrée.

un circuit de réglage de phase (3, 4, 5) ayant une entrée reliée à la sortie de l'oscillateur asservi, une entrée de commande de décalage par incréments de T/kp, T étant la période du signal d'entrée et p un nombre entier, et une sortie fournissant le signal d'échantillonnage A(t).

un convertisseur analogique numérique (1) convertissant le signal d'entrée E(t) en un signal de sortie S(t) numérique et recevant sur une entrée d'échantillonnage ledit signal d'échantillonnage A(t).

un circuit de commande de décalage (6, 7, 8) ayant deux entrées reliées à la sortie du circuit de réglage et à la sortie numérique et une sortie reliée à l'entrée de commande du circuit de réglage.

8. Dispositif selon la revendication 7, caractérisé en ce que le circuit de réglage de la phase du signal d'échantillonnage A(t) comprend un circuit (3) multiplicateur de la fréquence par p ayant une entrée reliée à la sortie de l'oscillateur asservi (2), un registre à décalage (5) à p étages ayant une entrée reliée à la sortie de l'oscillateur asservi (2) et une entrée de commande de décalage reliée à la sortie du multiplicateur de fréquence (3), et un multiplexeur (4) à p entrées reliées aux p étages du registre à décalage ayant une entrée de commande reliée à la sortie du circuit de commande pour sélectionner l'une des sorties du registre à décalage (5) en fonction de l'écart de phase relative mesurée.

9. Dispositif selon la revendication 7, caractérisé en ce que le circuit de réglage de la phase du signal d'échantillonnage A(t) comprend un circuit (3) multiplicateur de fréquence par p ayant une entrée reliée à la sortie de l'oscillateur asservi (2), ayant une entrée reliée à la sortie du multiplicateur de fréquence, un circuit (10) de suppression d'impulsions et une entrée de commande reliée à la sortie du circuit de commande pour supprimer un certain nombre d'impulsions du signal issu de ce multiplicateur de fréquence, et un circuit (9) diviseur par p ayant une entrée reliée à la sortie du circuit de suppression (10) dont la sortie fournit le signal d'échantillonnage A(t).

10. Dispositif selon la revendication 7, caractérisé en ce que le circuit de commande de décalage comporte un circuit de mesure (7) de la phase relative entre le signal d'échantillonnage et le signal d'entrée, une mémoire (8) dans laquelle est mémorisé un tableau de correspondance entre la phase relative mesurée et le nombre d'impulsions à supprimer dans le signal issu du multiplicateur, cette mémoire étant adressée par le signal de sortie du circuit de mesure de phase relative (7), cette mémoire délivrant alors un mot de commande permettant de commander le circuit de réglage de la phase du signal d'échantillonnage.

**Claims**

1. Method of sampling a sinusoidal signal E(t) of frequency F by a sampling signal A(t) of multiple frequency kF, said two signals having a minimum relative phase shift, characterized in that it comprises the following steps :

generation of a signal D(t) of frequency kF which is a multiple of the input frequency, phaselocked to the input signal E(t),

generation of a sampling signal A(t) of frequency kF from the signal D(t) of adjustable phase with respect to the input signal E(t) by increments of T/kp, T being the period of the input signal and p a positive integer,

generation of a phase reference signal obtained from the sampling signal A(t) and being a measure of the relative phase deviation of the sampling signal A(t) from the input signal E(t) ;

selection from amongst the possible phase adjustments of the sampling signal A(t) to minimize the relative phase deviation of said signal with respect to the phase reference value of the input signal E(t).

2. Method according to claim 1, characterized in that the digital signal S(t) at the output of the analog/digital converter 1 is a signal comprising binary multibit words.

3. Method according to claim 1, characterized in that the phase reference value of the input signal is equal to zero.

4. Method according to claim 2, characterized in that the input signal E(t) is the composite television signal of a simultaneous color television system, said television signal being divided into time intervals representing the sweep lines of a display member and comprising at the start of said intervals a sequence of high-frequency so called subcarrier sinusoidal signals, p being equal to 8 and k equal to 4n, n being an integer greater than or equal to 1.

5. Method according to claim 4, characterized in that the simultaneous color television system is the « PAL » system.

6. Method according to claim 4, characterized in that the simultaneous color television system is the « NTSC » system.

7. Device for sampling a sinusoidal signal E(t) of frequency F by a sampling signal A(t) of multiple frequency kf, said two signals having a relative minimum phase displacement, characterized in that it comprises :

a control oscillator (2) which permits generation of a phase reference signal D(t) of frequency kF phaselocked to the input signal ;

a phase control circuit (3, 4, 5) comprising an input connected to the output of the controlled oscillator, an input for controlling the shift by increments of T/kp, T being the period of the input signal and p a whole number, and an output furnishing the sampling signal A(t) ;

an analog/digital converter (1) converting the input signal E(t) to a digital output signal S(t) and receiving at a sampling input said sampling signal A(t) ;

a shift control circuit (6, 7, 8) comprising two inputs connected to the output of the control circuit and to the digital output respectively and an output connected to the control input of the control circuit.

8. Device according to claim 7, characterized in that the phase control circuit for the sampling signal A(t) includes a circuit (3) for multiplying the frequency by p having an input connected to the output of the controlled oscillator (2), a p-stage shift register (5) having an input connected to the output of the controlled oscillator (2) and a shift control input connected to the output of the frequency multiplier (3), and a multiplexer (4) with p inputs connected to the p stages of the shift register, having a control input connected to the output of the control circuit for selecting one of the outputs of the shift register (5) in dependence upon the measured relative phase deviation.

9. Device according to claim 7, characterized in that the phase control circuit for the sampling signal A(t) comprises a circuit (3) for multiplying the frequency by p having an input connected to the output of the controlled oscillator (2), an input connected to the output of the frequency multiplier, a pulse suppression circuit (10) and a control input connected to the output of the control circuit for suppressing a certain number of pulses of the signal originating from said frequency multiplier, and a divider circuit (9) which divides by p and has an input connected to the output of the suppression circuit (10) whose output furnishes the sampling signal A(t).

10. Device according to claim 7, characterized in that the shift control circuit comprises a circuit (7) for measuring the relative phase between the sampling signal and the input signal and a memory (8) in which is stored a correspondance table between the measured relative phase and the number of pulses to be suppressed in the signal furnished by the multiplier, said memory being addressed by the output signal of the relative phase measuring circuit (7), said memory then furnishing a command word permitting the control of the phase control circuit of the sampling signal.

**Patentansprüche**

1. Verfahren zur Abtastung eines sinusförmigen Signals E(t) der Frequenz F durch ein Abtastsignal A(t) der ein Vielfaches darstellenden Frequenz kF, wobei diese zwei Signale eine minimale relative Phasenverschiebung aufweisen, dadurch gekennzeichnet, daß es die folgenden Schritte umfaßt :

Erzeugung eines Signals D(t) der Frequenz kF, die ein Vielfaches der Eingangsfrequenz ist, und welches mit dem Eingangssignal E(t) phasenverriegelt ist,

Erzeugung eines Abtastsignals A(t) der Frequenz kF aus dem Signal D(t), mit einstellbarer Phase in bezug auf das Eingangssignal E(t), und zwar um Inkremente von T/Kp, worin T die Periode des Eingangssignals und p eine ganze positive Zahl ist,

Erzeugung eines Phasenreferenzsignals, das aus dem Abtastsignal A(t) erhalten wird und ein Maß für die relative Phasenabweichung des Abtastsignals A(t) von dem Eingangssignal E(t) ist ;

unter den möglichen Phaseneinstellungen des Abtastsignals A(t) wird derart ausgewählt, daß die relative Phasenabweichung dieses Signals gegenüber dem Phasenreferenzwert des Eingangssignals E(t) minimal gemacht wird.

2. Verfahren nach Anspruch 1, dadurch gekennzeichnet, daß das Digitalsignal S(t) am Ausgang des Analog/Digital-Umsetzers 1 ein Signal aus binären Multibit-Wörtern ist.

3. Verfahren nach Anspruch 1, dadurch gekennzeichnet, daß der Phasenreferenzwert des Eingangssignals gleich Null ist.

4. Verfahren nach Anspruch 2, dadurch gekennzeichnet, daß das Eingangssignal E(t) das zusammengesetzte Fernsehsignal eines Simultan-Farbfernsehsystems ist, wobei dieses Fernsehsignal in Zeitintervalle unterteilt ist, welche die Ablenkzeilen eines Anzeigeorgans darstellen, und am Anfang dieser Intervalle eine Folge von hochfrequenten, sogenannten Hilfsträger-Sinussignalen enthält, wobei p gleich 8 und k gleich 4n ist, mit n ganzzahlig und größer als oder gleich 1.

5. Verfahren nach Anspruch 4, dadurch gekennzeichnet, daß das Simultan-Farbfernsehsystem das « PAL »-System ist.

6. Verfahren nach Anspruch 4, dadurch gekennzeichnet, daß das Simultan-Farbfernsehsystem das « NTSC »-System ist.

7. Vorrichtung zur Abtastung eines sinusförmigen Signals E(t) der Frequenz F durch ein Abtastsignal A(t) der ein Vielfaches darstellenden Frequenz kf, wobei diese zwei Signale eine relative minimale Phasenverschiebung besitzen, dadurch gekennzeichnet, daß sie umfaßt :

einen geregelten Oszillator (2), der es gestattet, ein Phasenreferenzsignal D(t) der Frequenz kF zu erzeugen, das mit dem Eingangssignal phasenverriegelt ist ;

einen Phasenregelkreis (3, 4, 5), der einen mit dem Ausgang des geregelten Oszillators verbundenen Eingang, einen Eingang zur Steuerung der Verschiebung um Inkremente von T/kp, worin T die Periode des Eingangssignals und p eine ganze Zahl ist, und einen Ausgang aufweist, der das Abtastsignal A(t) liefert ;

einen Analog/Digital-Umsetzer (1), welcher das Eingangssignal E(t) in ein digitales Ausgangssignal S(t) umsetzt und an einem Abtasteingang das genannte Abtastsignal A(t) empfängt ;

eine Verschiebe-Steuerschaltung (6, 7, 8) mit zwei Eingängen, welche mit dem Ausgang des Regelkreises bzw. mit dem digitalen Ausgang verbunden sind, und einem Ausgang, der mit dem Steuereingang des Regelkreises verbunden ist.

8. Vorrichtung nach Anspruch 7, dadurch gekennzeichnet, daß der Phasenregelkreis für das Abtastsignal A(t) eine Schaltung (3) zum Multiplizieren der Frequenz mit p umfaßt, die einen Eingang aufweist, welcher mit dem Ausgang des geregelten Oszillators (2) verbunden ist, ein p-stufiges Schieberegister (5) umfaßt, das einen mit dem Ausgang des geregelten Oszillators (2) verbundenen Eingang und einen Verschiebesteuereingang aufweist, der mit dem Ausgang des Frequenzmultiplizierers (3) verbunden ist, und einen Multiplexer (4) mit p Eingängen aufweist, die mit den p Stufen des Schieberegisters verbunden sind, mit einem Steuereingang, der mit dem Ausgang der Steuerschaltung verbunden ist, um einen der Ausgänge des Schieberegisters (5) in Abhängigkeit von der gemessenen relativen Phasenabweichung auszuwählen.

9. Vorrichtung nach Anspruch 7, dadurch gekennzeichnet, daß der Phasenregelkreis für das Abtastsignal A(t) eine Schaltung (3) zum Multiplizieren der Frequenz mit p umfaßt, die einen mit dem Ausgang des geregelten Oszillators (2) verbundenen Eingang aufweist, mit einem Eingang, der an den Ausgang des Frequenzmultiplizierers angeschlossen ist, eine Impulsunterdrückungsschaltung (10) und einen Steuereingang umfaßt, der mit dem Ausgang der Steuerschaltung verbunden ist, um eine bestimmte Anzahl von Impulsen des Signals zu unterdrücken, das von diesem Frequenzmultiplizierer ausgeht, und eine durch p teilende Teilerschaltung (9) umfaßt, die einen mit dem Ausgang der Unterdrückungsschaltung (10) verbundenen Eingang aufweist, deren Ausgang das Abtastsignal A(t) liefert.

10. Vorrichtung nach Anspruch 7, dadurch gekennzeichnet, daß die Verschiebungssteuerschaltung eine Schaltung (7) zur Messung der relativen Phase zwischen dem Abtastsignal und dem Eingangssignal und einen Speicher (8) umfaßt, worin eine Entsprechungstabelle zwischen der gemessenen relativen Phase und der Anzahl von in dem vom Multiplizierer abgegebenen Signal zu unterdrückenden Impulsen abgespeichert ist, wobei dieser Speicher durch das Ausgangssignal der Schaltung (7) zur Messung der relativen Phase adressiert wird und wobei dieser Speicher dann ein Steuerwort abgibt, das es gestattet, den Phasenregelkreis des Abtastsignals zu steuern.

0 071 505

FIG.1

FIG.2

0 071 505

FIG.3

2

FIG.4

FIG.5